Europäisches Patentamt

European Patent Office

Office européen des brevets

(11) Publication number: **0 161 986 B1**

(12) **EUROPEAN PATENT SPECIFICATION**

(45) Date of publication of patent specification: **02.09.92**   (51) Int. Cl.⁵: **G01K 7/02**

(21) Application number: **85400871.1**

(22) Date of filing: **06.05.85**

The file contains technical information submitted after the application was filed and not included in this specification

(54) **Stable high temperature cables and devices made therefrom.**

(30) Priority: **07.05.84 AU 4865/84**
**20.02.85 AU 9368/85**

(43) Date of publication of application:
**21.11.85 Bulletin  85/47**

(45) Publication of the grant of the patent:
**02.09.92 Bulletin  92/36**

(84) Designated Contracting States:
**AT BE CH DE IT LI LU NL SE**

(56) References cited:
**EP-A- 0 078 675**
**GB-A- 674 068**
**GB-A- 1 347 236**
**GB-A- 2 107 516**
**US-A- 3 942 242**

(73) Proprietor: **NICROBELL PTY LIMITED**
**32 Parramatta Road**
**Lidcombe, NSW 2141(AU)**

(72) Inventor: **Burley, Noel Arthur**
**28 Somers Street**
**Mitcham Victoria, 3132(AU)**

(74) Representative: **Ores, Irène et al**
**CABINET ORES 6, Avenue de Messine**
**F-75008 Paris(FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

**Description**

This invention relates to electrically conductive cables, including thermocouple cables, and also includes thermocouple sensors made from the said thermocouple cables. The electrically conductive cables of the invention also include heat detectors and heating elements that are particularly useful at high temperatures.

The invention utilises nickel-base alloys, including those alloys which are used in the thermocouple system designated "type N" by such standards bodies as the Instrument Society of America, the American Society for Testing and Materials, the International Electrotechnical Commission and the British Standards Institution.

In one aspect the invention provides nickel-base thermocouple cables, and nickel-base thermocouple sensor systems made therefrom, having superior oxidation resistance, greater longevity and greater thermoelectric stability under longer time periods and over a range of higher temperatures up to 1300°C, than existing base-metal cables and sensor systems of the same general kind.

The invention also provides electrically conductive cables including such cables suitable for use as heat detectors and heating elements.

Nickel-base alloys have been used as thermocouples since the early part of this century. One of the commonly used thermocouples is the type K thermocouple (so designated by the Instrument Society of America). The positive type K thermoelement is a nickel-base alloy containing 9.25 percent by weight of chromium and 0.4 percent by weight of silicon, balance essentially nickel. The negative type K thermoelement is a nickel-base alloy containing 3 percent by weight of manganese, 2 percent by weight of aluminium, 1 percent by weight of silicon, with small amounts of iron and cobalt, and the balance essentially nickel.

The type K thermocouple is recommended to be used in an air atmosphere. At the higher temperatures the type K thermocouple fails because of its relatively poor oxidation resistance. One way in which attempts have been made to overcome this problem is to incorporate the type K thermocouple in a compacted ceramic-insulated thermocouple sensor assembly.

As is well known in the art a first step in the manufacture of such thermocouple sensors is to produce the so-called "MI" (mineral insulated) cable wich comprises a sheath containing one or more thermoelement conductor wires electrically insulated from the sheath (and from each other when two or more conductor wires are used) by compacted mineral insulation material.

The European Patent EP-0 078 675 discloses in particular a heat sensitive cable with a pair of conductors one of which is preferably a wire of nickel/chrome alloy, whereas the other conductor is a wire of copper/nickel alloy, wherein the nickel/chrome alloy comprises approximately 90 % nickel and 10 % chrome and the copper/nickel alloy comprises approximately 55 % copper and 45 % nickel.

The sheath of this cable is formed of either 304 or 304L stainless steel or nickel/chrome/iron alloy comprising approximately 75 % nickel, 15 % chrome and 10 % iron.

This means that the sheath and conductor alloys are substantially and significantly different compositions, this giving rise to a number of severe problems in properties and performance of conventional mineral-insulated integrally-sheathed (MIMS) conductor cables, which are discussed hereinafter in the present Application which specifically aims at overcoming them.

Patent GB-1 347 236 discloses a thermocouple having a positive limb formed of a nickel/chromium alloy and a negative limb formed of a nickel/silicon alloy.

The positive thermoalloy (CERLOY P) disclosed in this reference is essentially a Ni-13 (wt.-%Cr, although up to 15 Cr is allowed. The sheath alloy of the instant invention contains 14 Cr. The basic CERLOY P alloy is thus different from Nicrosil (Type NP) in that the former normally contains no Si or Mg. The CERLOY P alloy is therefore grossly inferior in oxidation resistance to Nicrosil. Moreover, CERLOY P may contain up to 3 % Mn. As stated in the present specification, the absence of Mn from the sheath alloy is part of the essence of the invention, as Mn is the principal contaminant of the thermocouple wires which causes thermoelectric instability in conventional MIMS cables which are described in the specification.

The negative thermoalloy CERLOY N is grossly inferior in oxidation resistance to NISIL (Type NN), as the Si content of the former is too low to prevent internal oxidation, which does not occur in Nisil. Furthermore, CERLOY N contains no Mg, the presence of which in Nisil results in an order of magnitude increase in oxidation resistance compared to Mg-free alloys of otherwise similar composition.

Patent GB-674 068 teaches a Cu/Ni alloy sheath and type k thermocouple conductors, whereas US-3 942 242 teaches a stainless steel sheath and a chromel core, i.e. some specific alloys which are substantially different from those of the present invention and disclosed hereinafter in the present specification.

Furthermore, the American reference discloses a device which forms a non-standard thermocouple.

In the accompanying drawings :

Fig. 1 illustrates a typical MI cable containing two conductor wires (thermoelements) ;

Fig. 2 illustrates two basic designs for stagnation temperature probes as more fully discussed below ; and

Fig. 3 illustrates the large negative temperature coefficient of resistance of the densely compacted insulation in heat sensors according to the invention as more fully discussed below.

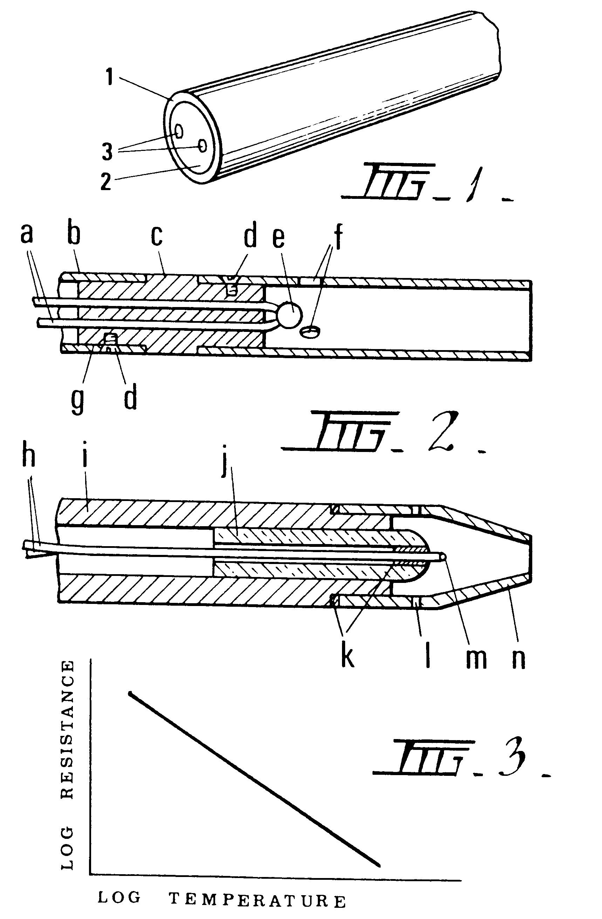

The MI cable illustrated in Fig. 1 is of a conventional type comprising a sheath 1, compacted insulation 2 and conductor wires (thermoelements) 3.

Further details of the manufacture of MI cable as illustrated in Fig. 1 are given in Example 1 below.

To make an actual sensor from this cable, the cable is cut and the ends of the conductors are exposed by removing some of the insulation therefrom. The exposed ends of the conductors are then joined to form a thermojunction, which may be accomplished for example by crimping and/or welding.

The thermojunction may simply be left exposed for use in appropriate environments or may be protected by capping the sheath over the thermojunction with or without insulant.

The latter type of thermocouple sensor has come into common use because it isolates the thermocouple wires from environments that may cause rapid deterioration and it provides excellent high-temperature insulation for the thermocouple conductor wires. The sheath can be made of a material which, hopefully, is compatible with the environments and processes in which it is being used and which provides a measure of mechanical protection. There are numerous commercial suppliers of type K thermocouples in compacted ceramic-insulated integrally-sheathed forms.

At temperatures above about 1050ºC known types of compacted ceramic-insulated integrally-sheathed cables and thermocouples fail prematurely because of factors such as-

(i) the materials of which their sheaths are made, such as inconel and stainless steel, fail by deterioration due to oxidation or other accelerated interaction with their gaseous environment;

(ii) the individual alloys of the type K thermocouple fail as a result of accelerated oxidation by low-pressure air residual in the compacted ceramic insulation;

(iii) the thermoelement conductor wires fail mechanically because of substantial alternating strains imposed during thermal cycling. These strains are caused primarily by longitudinal stresses which arise because of substantially different temperature coefficients of linear expansion of the sheath and thermoelement materials. Some typical average values of these coefficients of expansion are -

| Component | Material | $x10^{-6}.ºC^{-1}$ ( 1100ºC) |
|---|---|---|
| sheath | stainless steel | 20 |
| thermoalloys | type K | 17 |

(iv) the thermoelement conductor alloys are contaminated by dissolution of extraneous elements received from a different sheath alloy by thermal diffusion through the compacted insulating material. These elements, eg. Mn, Fe, Mo, Cu, cause substantial changes in the thermoelectromotive force of the thermocouple.

(v) the composition of the thermoelement conductor wires is altered by exposure of the thermocouple to prolonged nuclear irradiation, which results in the transmutation of one or more elements in the alloy.

As a result, there is a need for a new integral compacted ceramic-insulated cable suitable as a heating element or for production of thermocouple sensors which is substantially free of the degradative influences described above and which demonstrates enhanced environmental and thermoelectric stability at temperatures significantly in excess of 1050ºC.

It is believed, therefore, that a new compacted ceramic-insulated integrally-sheathed cable, substantially free of degradative influences such as accelerated oxidation, differential thermal stresses, cross-contamination by diffusion, and transmutations and demonstrating enhanced resistance to environmental interactions and to drifts in thermal e.m.f. and resistivity at temperatures up to 1300ºC in a variety of different atmospheres, is an advancement in the art.

It is also an advancement of the art that certain causes of thermoelectric instability which plague conventional base-metal thermocouple transducers, namely accelerated oxidation, inhomogeneous short-range structural ordering, nuclear transmutations, and magnetic transformations, are virtually eliminated in the new thermocouple sensor of this invention. This is because the compositions of the type N thermoelement conductor wires incorporated in the new integral compacted ceramic-insulated thermocouple sensor are such as to virtually eliminate thermal-emf shifts due to oxidation, in particular internal oxidation, and short-range order, contain no strongly transmuting component elements, and have magnetic transformations below room temperatures.

OBJECTS AND SUMMARY OF INVENTION

It is one of the objects of this invention to provide an integral compacted base-metal thermocouple cable and sensor which are thermoelectrically stable up to 1300°C. It is a further object of this invention to provide an integral compacted base-metal thermocouple cable and sensor which are highly oxidation resistant up to 1300°C.

It is another object of the invention to provide electrically conductive cables and heating elements which have similar advantages at high temperatures.

It is a further object of this invention to provide electrically conductive cables and heat detectors which have similar advantages at high temperatures.

These and other objects of this invention are achieved, in one aspect of the invention, by the use of two specific alloys, and certain compositional variants of these alloys, as sheath materials. The said alloys are similar to those which are suitable for use as the positive and negative thermoelements of the thermocouple. The chemical compositional tolerances (percentages by weight) for the alloying constituents of the alloys for the positive and negative thermoelements of the thermocouple conductors are -

| Positive Alloy | Element | Negative Alloy |
|---|---|---|
| 14.2 ± 0.15 ----------- | Cr -------------- | 0.02 max. |
| 1.4 ± 0.05 ----------- | Si -------------- | 4.4 + 0.2 |
| 0.1 ± 0.03 ----------- | Fe -------------- | 0.1 + 0.03 |
| 0.03 max. ----------- | C -------------- | 0.03 max. |
| | Mg -------------- | 0.1 ± 0.05 |
| Balance ----------- | Ni -------------- | Balance |

Thermocouples of these alloys are designated 'type N' by the Instrument Society of America and other such bodies.

The first sheath alloy of this invention consists essentially of:-
(a) from about 13.0 weight percent to about 15.0 weight percent of chromium, from about 1.0 weight percent to about 2.0 weight percent of silicon, from about 0.03 weight percent to about 0.25 weight percent of magnesium, and the balance nickel.

The second sheath alloy of this invention consists essentially of:-
(b) from about 3.0 weight percent to about 5.0 weight percent of silicon, from about 0.03 weight percent to about 0.25 weight percent of magnesium and the balance nickel.

The refractory insulating materials for the integral compacted base-metal thermocouple sensor include magnesium oxide, beryllium oxide, aluminium oxide, zirconium oxide and other suitable refractory oxides.

This invention also includes several applications of the novel device. One of these applications relates to the measurement of the temperature of moving gases such as are encountered in gas-turbines, flues, pipes, chimneys and other confined spaces intended for the conveyance of gases.

If an attempt is made to use a solid sensor element or probe to measure temperatures in a body of gas moving relative to the element or probe, a heating effect due to adiabatic compression of the gaseous layer contiguous to the surface of the sensitive probe results in an elevated temperature measurement error. This problem is conventionally combatted by the use of a 'stagnation-temperature probe'. Basic designs of such a probe are exemplified in Figure 2, wherein the components are:-

| a, h | thermoelement conductor wires |
| b, i, n | stagnation tube componenets |
| c | plastic |
| d | hold screw |
| e, m | measurement thermojunction |
| f, l | vent holes |
| g | tight fit |
| j | silica tube |
| k | cement |

The construction usually consists of a stem protruding into the gas stream with a thermoelectric junction in some sort of cup at its end. The thermoelectric junction is located in the 'stagnation zone' of the gas-flow disturbance produced by this cup and its associated orifices. These devices, in general, are characterised by flow restrictions suited to nearly stopping the gas-flow at the location of the measuring thermoelectric junction. The idea is to obtain the temperature reading that would occur were there no relative velocity between the gas and the sensor probe, that is, the temperature that would prevail in the absence of the thermoelectric stagnation probe.

Stagnation probe thermocouples, particularly those employed to measure gas temperatures in high-performance gas-turbine engines, suffer from several inherent error sources additional to that attributed above to adiabatic compression. Examples of these additional error sources include thermal e.m.f. drift in base-metal thermocouple alloys due to high-temperature corrosion, catalysis of incompletely combusted air/fuel mixtures by conventional rare-metal thermocouples, and heat radiation to and from thermocouple measuring thermojunctions from and to the internal surfaces of the gas containment vessel.

These errors in temperature measurement additional to the adiabatic compression error will be largely eliminated by the use of type N thermocouples as the temperature sensor incorporated in the stagnation probe, more particularly the type N thermocouples in the form of the integral compacted thermocouple sensor of this invention.

Such a stagnation temperature probe incorporating a type N thermocouple, either as a bare-wire thermocouple or as an integral compacted thermocouple sensor of this invention, is a significant advancement in the art. A further advancement still is to utilise one or any of the alloys specified (a), (a1), (a2), (a3), (b), (b1), (b2), (b3) below as the stagnation tube of the stagnation probe in lieu of any of the stainless steels or any of the other alloys conventionally used.

Another application of the novel device relates to the detection, location and monitoring of expected or unexpected sources of heat such as may be encountered in machinery, storage spaces such as bins, kilns, silos, etc.; pipelines, buildings, instruments, ships, aircraft, nuclear reactors, and in many other locations. Such devices, which are in most respects similar in construction to the conventional MI cable described above, are well known in the art. One essential difference is that the densely compacted insulation has insulating properties including a large negative temperature coefficient of resistance, as is illustrated in principle in Fig. 3.

Incipient local sources of heat are detected by this device because the conductivity of the compacted insulation in the vicinity of such sources increases, over the temperature range up to about 900°C, causing local short-circuiting of the thermoelectric conductors to form a local measuring thermojunction. This reversible effect allows the location, intensity and duration of a temporal heat source to be determined and monitored.

Unfortunately, conventional heat sensors of this kind show the same tendency to premature failure, by the same causes shown by MI cables of the conventional kind, when exposed to high temperatures for prolonged periods of time. Novel heat sensors made from type N alloys, in the manner provided by this invention, are a significant advancement in the art in that they are virtually free of the degradative influences described above for conventional MI cable. The virtual freedom shown by the novel heat detectors from nuclear transmutations is of singular importance, as they are thus suitable for use inside nuclear reactors for substantial periods of time. Conventional heat sensors of MI cable form are not free of transmutational effects.

Conventional heat detectors will fail electrically when heated for periods of time at temperatures above about 1100°C. The novel heat detector will withstand temperatures up to 1300°C, such as might be caused by the direct impingement of flame, for prolonged periods of time.

A further application of the novel device relates to resistive heating elements such as are used for raising the temperature of heated enclosures such as furnaces, ovens, baths, etc., and other spaces. Such heating devices, which are in most respects similar in construction to conventional MI cable described above, are well known in the art. One essential difference is that the conductor elements are made of a conventional resistor alloy such as 'nichrome' (nichrome is a trade name of the Driver-Harris Company of U.K.,Italy, France, Australia and U.S.A.) which provides resistive heating on the passage of electric current.

Unfortunately conventional heater elements of this kind show the same tendency to premature failure from the same causes as shown by MI cables of the conventional kind. Novel heater elements made from type N alloys in the manner provided by this invention are a significant advancement in the art in that they are virtually free of the degradative influences described above for conventional MI cable.

It is fortuitous that the resistivity and the temperature coefficient of resistance of the positive type N alloys are comparable with those of nichrome. Such type N alloys can thus most efficaceously be used as the resistive heating element in the novel invention at high temperatures.

| Alloy | Resistivity at $20^{o}C$ ($\mu\Omega.cm$) | Temperature Coefficient of Resistance ($\Omega.\Omega^{-1}.^{o}C^{-1}$) | |
|---|---|---|---|
| nichrome | 110 | $-\ 0.00004$ )<br>$+\ 0.00007$ ) | * |
| positive N | 95 | $+\ 0.00011$ | |

*different reports

The net effects of these properties are to make the resistivity of a positive N alloy comparable with that of nichrome at elevated temperatures.

## DETAILED DESCRIPTION OF THE PREFERRED EMBODIMENTS

For a better understanding of the present invention together with other and further objects, advantages, and capabilities thereof, reference is made to the following disclosure.

The integral base-metal thermocouple sensor of the present invention has excellent oxidation resistance and thermoelectric stability at temperatures up to 1300°C. It has been found that the alloys of this invention change very little both in thermal e.m.f. output and degree of oxidation even after about 1000 hours of exposure at 1250°C. When compared with the conventional thermoalloys of type K and sheath alloys of inconel and stainless steel, which materials are conventionally used in existing integral compacted thermocouple sensors, the integral compacted thermocouple sensor of this invention incorporating the type N specified thermoelements and sheaths of alloys (a) and (b) described above show markedly better thermoelectric and environmental stability to a degree hitherto unattainable with conventionally used base-metal alloys.

The thermoelectric conductor alloys to be incorporated in this invention consist essentially of the type N alloys specified above. The sheath alloys to be incorporated in this invention consist essentially of the elemental compositions (a) and (b) described above.

Preferred compositions of type (a) consist essentially of:-

(a1) from about 13.9 weight percent to about 14.5 weight percent of chromium, from about 1.3 weight percent to about 1.5 weight percent of silicon, from about 0.05 weight percent to about 0.20 weight percent of magnesium, and the balance nickel, or more preferably -

(a2) from about 14.05 percent weight to about 14.35 percent weight of chromium, from about 1.35 percent weight to about 1.45 percent weight of silicon, from about 0.10 weight percent to about 0.20 weight percent of magnesium, about 0.15 percent weight maximum of iron, about 0.05 percent weight maximum of carbon, and the balance nickel.

A specific preferred composition of type (a) consists essentially, within the usual limits of manufacturing tolerance of:-

(a3) 14.2 weight percent chromium,

1.4 weight percent silicon,

0.1 weight percent iron,

0.03 weight percent magnesium and the balance nickel.

Preferred compositions of type (b) consist essentially of:-

(b1) from about 4.0 weight percent to about 4.8 weight percent of silicon, from about 0.05 weight percent to about 0.20 weight percent of magnesium, and the balance nickel, or more preferably -

(b2) from about 4.2 percent weight to about 4.6 percent weight silicon, from about 0.10 weight percent to about 0.20 weight percent magnesium, about 0.05 weight percent maximum chromium, about 0.15 weight percent maximum iron, about 0.05 percent weight maximum of carbon, and the balance nickel.

A specific preferred composition of type (b) consists essentially, within the usual limits of manufacturing tolerance of:-

(b3) 4.4 weight percent silicon,

0.1 weight percent iron,

0.1 weight percent magnesium

and the balance nickel

It will be clearly understood that when the cable contains a single thermoelement, the most preferred sheath material is the thermoelectrically opposite alloy to the said single thermoelement. In this case a sensor is formed by joining the thermoelement to the sheath. When more than one thermoelement is employed and the thermoelements are made of dissimilar alloys, the sheath material is most preferably made of the same alloy as any one of the thermoelements.

In a further modification of the invention, of particular value in hostile environments such as are encountered in the chemical and petroleum industries, the sheath may be fabricated of appropriate corrosion resistant material.

The invention will be further illustrated by the following non-limiting examples.

EXAMPLE 1

The integral compacted thermocouple cable of this Example is fabricated using existing manufacturing procedures. They begin with thermoelectrically matched thermoelement wires surrounded by non-compacted ceramic insulating material held within a metal tube. By rolling, drawing, swaging, or other mechanical reduction processes the tube is reduced in diameter and the insulation is compacted around the wires. The manufacturing process parameters are adjusted so that the ratios of sheath diameter to wire-size and sheath wall-thickness offer a balance between maximum wall-thickness and suitable insulation spacing for effective insulation resistance at elevated temperatures.

An important feature of the fabrication process is that considerable attention is given to the initial cleanliness and chemical purity of the components and retention of a high degree of cleanliness and dryness throughout fabrication. As already noted above, to make an actual sensor from this cable, the cable is cut and the ends of the conductors are exposed by removing some of the insulation therefrom. The exposed ends of the conductors are then joined to form a thermojunction, which may be accomplished for example by crimping and/or welding.

The thermojunction may simply be left exposed for use in appropriate environments, or may be protected by capping the sheath over the thermojunction with or without insulant. The measuring thermojunction of the thermocouple is usually, but not always, electrically isolated from the end of the sheath.

In this example, the alloys for the thermocouple conductor wires are those specified above as type N and the alloy for the sheath is that specified in (a) above.

An important feature of the finished product of this example is that the essential similarity between the properties of the sheath alloy and the thermocouple conductor alloys virtually eliminates the destructive influences of thermocouple contamination by cross-diffusion, mechanical failure due to differential thermal stresses, and accelerated oxidation above about 1050°C. The strains caused by longitudinal stresses arising during thermal cycling are small because of the very small differences in the temperature coefficients of lineal expansion between the materials of the sheath and of the thermoelement conductors. Some typical average values of these coefficients of expansion are -

| Component | Material | $\times 10^{-6}$ °C$^{-1}$ (1200°C) |
|---|---|---|
| sheath thermoalloys | alloy (a) above type N | 17.5 17.0 (average of positive and negative) |

EXAMPLE 2.

7

The integral compacted thermocouple cable and sensor of this Example is the same as described in Example 1, except that the alloy for the sheath is that specified (a1) above used in lieu of that alloy specified (a) above.

EXAMPLE 3.

The integral compacted thermocouple cable and sensor of this Example is the same as described in Example 1, except that the alloy for the sheath is that specified (a2) above used in lieu of that alloy specified (a) above.

EXAMPLE 4.

An integral compacted thermocouple cable is made as in Example 1, the composition of the components being:-

positive thermoelement    - alloy (a3)
negative thermoelement    - alloy (b3)
sheath                    - alloy (a3)

EXAMPLES 5 to 8

The thermocouple cables of these Examples are the same, respectively, as those described in Examples 1 to 4 except that the sheath alloys are strengthened by addition of one or more components known for the purpose of increasing mechanical strength of said alloys at high temperature for example one or more of manganese, iron, molybdenum, cobalt, tungsten, and oxide-particle dispersions.

EXAMPLES 9 to 16

The integral compacted thermocouple cables and sensors of these Examples are the same, respectively, as those described in Examples 1 to 8, except that the sheath alloys are coated to further inhibit chemical high-temperature corrosive degradation. Such coatings include those deposited by a wide variety of conventional protective coating processes such as electrolytic deposition from aqueous solution or fused salts or other electrolytic liquids, such as metallic diffusion processes including aluminizing, chromizing, calorizing and similar processes, such as overlay coatings, and other protective coating processes.

EXAMPLE 17

The integral compacted thermocouple cable and sensor of this Example is the same as described in Example 1, except that the alloy for the sheath is that specified (b) above used in lieu of that alloy specified (a) above.

EXAMPLE 18

The integral compacted thermocouple cable and sensor of this Example is the same as described in Example 1, except that the alloy for the sheath is that specified (b1) above used in lieu of that alloy specified (a) above.

EXAMPLE 19

The integral compacted thermocouple cable and sensor of this Example is the same as described in Example 1, except that the alloy for the sheath is that specified (b2) above used in lieu of that alloy specified (a) above.

EXAMPLE 20

The integral compacted thermocouple cable of this example is the same as Example 4 except that the sheath is composed of alloy (b3) instead of alloy (a3).

EXAMPLES 21 to 24

The integral compacted thermocouple cables and sensors of these Examples are the same, respectively, as those described in Examples 17 to 20 except that the sheath alloys contain in addition up to 1.0 weight percent of one or more elements known for the purpose of inhibiting metallurgical grain growth, occurring at high temperature, for example niobium or titanium.

### EXAMPLES 25 to 28

The integral compacted thermocouple cables and sensors of these Examples are the same, respectively, as those described in Examples 17 to 20, except that the sheath alloys contain in addition an appropriate amount of one or more components known for the purpose of increasing mechanical strength of said alloys at high temperature, for example manganese, iron, molybdenum, cobalt, tungsten, and oxide-particle dispersions.

### EXAMPLES 29 to 32

The integral compacted thermocouple cables and sensors of these Examples are the same as those described, respectively, in Examples 17 to 20, except that the sheath alloys contain in addition up to 1.0 weight percent of one or more elements known for the purpose of inhibiting metallurgical grain growth occurring at high temperature, for example niobium or titanium; and also an appropriate amount of one or more components known for the purpose of increasing mechanical strength of said alloys at high temperature, for example manganese, iron, molybdenum, cobalt, tungsten, and oxide-particle dispersions.

### EXAMPLES 33 to 48

The integral compacted thermocouple cables and sensors of these Examples are the same respectively, as those described in Examples 17 through 32, except that the sheath alloys are coated by any of the processes and for the purposes described-in Example 9 through Example 16.

### EXAMPLES 49 to 96

Heat detectors in accordance with the invention are produced in the same manner as the integral compacted cables of examples 1 through 48 except that the refractory compacted insulant incorporates insulating properties with a high negative temperature coefficient of resistance.

### EXAMPLES 97 to 576

Heating elements in accordance with the invention are produced in the same manner as the integral compacted cables of examples 1 through 96, except that a single resistive heating conductor is used in each case and the said conductor is composed of an alloy which is respectively: positive type N, (a), (a1), (a2) or (a3).

## Claims

1. A compacted mineral-insulated integrally sheathed cable, wherein the cable includes at least one thermoelement composed of a type N alloy, and the sheath is composed of an alloy selected from alloys (a) and (b), wherein alloy (a) comprises from 13.0 weight percent to 15.0 weight percent of chromium, from 1.0 weight percent to 2.0 weight percent of silicon, from 0.03 weight percent to 0.25 weight percent of magnesium and the balance nickel, with impurity levels of iron and carbon not exceeding 0.15 weight percent and 0.05 weight percent, respectively, and alloy (b) comprises from 3.0 weight percent to 5.0 weight percent of silicon, from 0.03 weight percent to 0.25 weight percent of magnesium and the balance nickel, with impurity levels of chromium, iron and carbon not exceeding 0.05 weight percent, 0.15 weight percent and 0.05 weight percent, respectively.

2. A cable according to Claim 1, wherein the sheath is composed of an alloy (a1) consisting essentially of from 13.9 weight percent to 14.5 weight percent of chromium, from 1.3 weight percent to 1.5 weight percent of silicon, from 0.05 weight percent to 0.20 weight percent of magnesium, and the balance nickel, with impurity levels of iron and carbon not exceeding 0.15 weight percent and 0.05 weight percent, respectively.

3. A cable according to Claim 1, wherein the sheath is composed of an alloy (a2) consisting essentially of from 14.05 weight percent to 14.35 weight percent of chromium, from 1.35 weight percent to 1.45 weight percent of silicon, from 0.10 weight percent to 0.20 weight percent of magnesium, 0.15 weight percent maximum of iron, 0.05 weight percent maximum of carbon, and the balance nickel.

4. A cable according to Claim 1, wherein the sheath is composed of an alloy (a3) consisting essentially of 14.2 weight percent chromium, 1.4 weight percent silicon, 0.1 weight percent iron, 0.03 weight percent magnesium, 0.05 weight percent maximum carbon and the balance nickel.

5. A cable according to Claim 1, wherein the sheath is composed of an alloy (b1) consisting essentially of from 4.0 weight percent to 4.8 weight percent of silicon, from 0.05 weight percent to 0.20 weight percent of magnesium, and the balance nickel, with impurity levels of chromium, iron and carbon not exceeding 0.05 weight percent, 0.15 weight percent and 0.05 weight percent, respectively.

6. A cable according to Claim 1, wherein the sheath is composed of an alloy (b2) consisting essentially of from 4.2 weight percent to 4.6 weght percent silicon, from 0.10 weight percent to 0.20 weight percent magnesium, 0.05 weight percent maximum chromium, 0.15 weight percent maximum iron, 0.05 weight percent maximum of carbon, and the balance nickel.

7. A cable according to Claim 1, wherein the sheath is composed of an alloy (b3) consisting essentially of 4.4 weight percent silicon, 0.1 weight percent iron, 0.1 weight percent magnesium, 0.05 weight percent maximum chromium, 0.05 weight percent maximum carbon and the balance nickel.

8. A cable according to Claim 1, wherein the cable includes a thermoelement composed of a positive type N alloy and a thermoelement composed of a negative type N alloy and the sheath is composed of a positive type N alloy.

9. A cable according to Claim 1, wherein the cable includes a thermoelement composed of a positive type N alloy and a thermoelement composed of a negative type N alloy and the sheath is composed of a negative type N alloy.

10. A cable according to Claim 1, wherein the cable includes only one thermoelement, said thermoelement is composed of a positive type N alloy and the sheath is composed of a negative type N alloy.

11. A cable according to Claim 1, wherein the cable contains only one thermoelement, said thermoelement is composed of a negative type N alloy and the sheath is composed of a positive type N alloy.

12. A cable according to any one of Claims 1 to 7, wherein the cable includes a thermoelement composed of a positive type N alloy and a thermoelement composed of a negative type N alloy.

13. A cable according to Claim 1, wherein the cable includes only one thermoelement, said thermoelement is composed of a positive type N alloy and the sheath is composed of an alloy selected from alloys (b), (b1), (b2) and (b3) wherein
alloy (b) comprises from 3.0 weignt percent to 5.0 weight percent of silicon, from 0.03 weight percent to 0.25 weight percent of magnesium and the balance nickel, with impurity levels of chromium, iron and carbon not exceeding 0.05 weight percent, 0.15 weight percent and 0.05 weight percent, respectively;
alloy (b1) comprises from 4.0 weight percent to 4.8 weight percent of silicon, from 0.05 weight percent to 0.20 weight percent of magnesium, and the balance nickel, with impurity levels of chromium, iron and carbon not exceeding 0.05 weight percent, 0.15 weight percent and 0.05 weight percent, respectively;
alloy (b2) comprises from 4.2 weight percent to 4.6 weight percent silicon, from 0.10 weight percent to 0.20 weight percent magnesium, 0.05 weight percent maximum chromium, 0.15 weight percent maximum iron, 0.05 weight percent maximum of carbon, and the balance nickel; and
alloy (b3) comprises 4.4 weight percent silicon, 0.1 weight percent iron, 0.1 weight percent magnesium 0.05 weight percent maximum chromium, 0.05 weight percent maximum carbon and the balance nickel.

14. A cable according to Claim 1, wherein the cable contains only one thermoelement, said thermoelement is composed of a negative type N alloy and the sheath is composed of an alloy selected from alloys (a), (a1), (a2) and (a3) wherein

alloy (a) comprises from 13.0 weight percent to 15.0 weight percent of chromium, from 1.0 weight percent to 2.0 weight percent of silicon, from 0.03 weight percent to 0.25 weight percent of magnesium, and the balance nickel, with impurity levels of iron and carbon not exceeding 0.15 weight percent and 0.05 weight percent, respectively;

alloy (a1) comprises from 13.9 weight percent to 14.5 weight percent of chromium, from 1.3 weight percent to 1.5 weight percent of silicon, from 0.05 weight percent to 0.20 weight percent of magnesium and the balance nickel, with impurity levels of iron and carbon not exceeding 0.15 weight percent and 0.05 weight percent, respectively;

alloy (a2) comprises from 14.05 weight percent to 14.35 weight percent of chromium, from 1.35 weight percent to 1.45 weight percent of silicon, from 0.10 weight percent to 0.20 weight percent of magnesium, 0.15 weight percent maximum of iron, 0.05 weight percent maximum of carbon, and the balance nickel; and

alloy (a3) comprises 14.2 weight percent chromium, 1.4 weight percent silicon, 0.1 weight percent iron, 0.03 weight percent magnesium, 0.05 weight percent maximum carbon, and the balance nickel.

**15.** A resistive heating cable particularly useful for operation at high temperatures comprising a cable according to Claim 1, wherein the or each thermoelement is a resistive heating element and the sheath is composed of an alloy chosen from positive type N alloys, negative type N alloys, and alloys (a), (a1), (a2), (a3), (b), (b1), (b2) and (b3) as defined in Claims 13 and 14.

**16.** A resistive heating element according to Claim 15, wherein the sheath alloy is strengthened by the addition of one or more components known for the purpose of increasing mechanical strength of said alloys at high temperature.

**17.** A resistive heating element according to Claim 16, in which the said components are chosen from manganese, iron, molybdenum, cobalt, tungsten, and oxide-particle dispersions.

**18.** A heat detector operable at temperatures above 1100°C comprising an elongated compacted mineral insulated integrally sheathed cable as defined in any one of Claims 1 to 14 disposed in an environment where local rises in temperature may occur, causing local increase in the conductivity of the insulating material, said detector including means for determining the location of the said local increase in conductivity and hence the location of the said rise in temperature.

**19.** A stagnation temperature probe incorporating a type N thermocouple as the temperature sensor, said thermocouple being made from a cable as defined in any one of Claims 1 to 14.

**Patentansprüche**

**1.** Verdichtetes, mineralisch isoliertes, mit integeriertem Mantel versehenes Kabel, bei dem das Kabel wenigstens ein aus einer N-Typ-Legierung zusammengesetztes thermoelektrisches Element einschließt, und der Mantel aus einer aus Legierungen (a) und (b) ausgewählten Legierung zusammengesetzt ist, bei dem Legierung (a) von 13,0 bis 15,0 Gewichtsprozent Chrom, von 1,0 bis 2,0 Gewichtsprozent Silicium, von 0,03 bis 0,25 Gewichtsprozent Magnesium und im übrigen Nickel umfaßt, mit Verunreinigungsgraden an Eisen und Kohlenstoff, die 0,15 bzw. 0,05 Gewichtsprozent nicht übersteigen, und Legierung (b) von 3.0 bis 5,0 Gewichtsprozent Silicium, von 0,03 bis 0,25 Gewichtsprozent Magnesium und im übrigen Nickel umfaßt, mit Verunreinigungsgraden an Chrom, Eisen und Kohlenstoff, die 0,05, 0,15 bzw. 0.05 Gewichtsprozent nicht übersteigen.

**2.** Kabel nach Anspruch 1, bei dem der Mantel aus einer Legierung (a1) gebildet ist, die sich im wesentlichen auf von 13,9 bis 14,5 Gewichtsprozent Chrom, von 1,3 bis 1,5 Gewichtsprozent Silicium, von 0,05 bis 0,20 Gewichtsprozent Magnesium und im übrigen Nickel zusammensetzt, mit Verunreinigungsgraden an Eisen und Kohlenstoff, die 0,15 bzw. 0,05 Gewichtsprozent nicht übersteigen.

**3.** Kebel nach Anspruch 1, bei dem der Mantel aus einer Legierung (a2) gebildet ist, die sich im wesentlichen aus von 14,05 bis 14,35 Gewichtsprozent Chrom, von 1,35 bis 1,45 Gewichtsprozent Silicium, von 0,10 bis 0,20 Gewichtsprozent Magnesium, maximal 0,15 Gewichtsprozent Eisen, maximol 0,05 Gewichtsprozent Kohlenstoff und im übrigen Nickel zusammensetzt.

4. Kabel nach Anspruch 1, bei dem der Mantel aus einer Legierung (a3) gebildet ist, die sich im wesentlichen aus 14,2 Gewichtsprozent Chrom, 1,4 Gewichtsprozent silicium, 0,1 Gewichtsprozent Eisen, 0,03 Gewichtsprozent Magnesium, maximal 0,05 Geweichtsprozent Kohlenstoff im übrigen Nickel zusammensetzt.

5. Kabel nach Anspruch 1, bei dem der Mantel aus einer Legierung (b1) gebildet ist, die sich im wesentlichen aus von 4,0 bis 4,8 Gewichtsprozent Silicium, von 0,05 bis 0,20 Gewichtsprozent Magnesium und im übrigen Nickel zusammensetzt, mit Verunreinigungsgraden an Chrom, Eisen und Kohlenstoff, die 0,05, 0,15 bzw. 0,05 Gewichtsprozent nicht übersteigen.

6. Kabel nach Anspruch 1, bei dem der Mantel aus einer Legierung (b2) gebildet ist, die sich im wesentlichen aus von 4,2 bis 4,6 Gewichtsprozent Silicium, von 0,10 bis 0,20 Gewichtsprozent Magnesium, maximal 0,05 Gewichtsprozent Chrom, maximal 0,15 Gewichtsprozent Eisen, maximal 0,05 Gewichtsprozent Kohlenstoff und im übrigen Nickel zusammensetzt.

7. Kabel nach Anspruch 1, bei dem der Mantel aus einer Legierung (b3) gebildet ist, die sich im wesentlichen aus 4,4 Gewichtsprozent Silicium, 0,1 Gewichtsprozent Eisen, 0,1 Gewichtsprozent Magnesium, maximal 0,05 Gewichtsprozent Chrom, maximal 0,05 Gewichtsprozent Kohlenstoff und im übrigen Nickel zusammensetzt.

8. Kabel nach Anspruch 1, bei dem das Kabel ein thermoelektrisches Element einschließt, das aus einer positiven N-Typ-Legierung gebildet ist, und ein thermoelektrisches Element, das aus einer negativen N-Typ-Legierung gebildet ist, und bei dem der Mantel aus einer positiven N-Typ-Legierung gebildet ist.

9. Kabel nach Anspruch 1, bei dem das Kabel ein thermoelektrisches Element einschließt, das aus einer positiven N-Typ-Legierung gebildet ist, und ein thermoelektrisches Element, das aus einer negativen N-Typ-Legierung gebildet ist, und bei dem der Mantel aus einer negativen N-Typ-Legierung gebildet ist.

10. Kabel nach Anspruch 1, bei dem das Kabel lediglich ein thermoelektrisches Element einschließt, wobei das thermoelektrische Element aus einer positiven N-Typ-Legierung und der Mantel aus einer negativen N-Typ-Legierung gebildet sind.

11. Kabel nach Anspruch 1, bei dem das Kabel nur ein thermoelektrisches Element enthält, wobei das thermoelektrische Element auf einer negativen N-Typ-Legierung und der Mantel aus einer positiven N-Typ-Legierung gebildet sind.

12. Kabel nach einem der Ansprüche 1 bis 7, bei dem das Kabel ein thermoelektrisches Element einschließt, das aus einer positiven N-Typ-Legierung gebildet ist, und ein thermoelektrisches Element, das aus einer negativen N-Typ-Legierung gebildet ist.

13. Kabel nach Anspruch 1, bei dem das Kabel nur ein thermoelektrisches Element einschließt, wobei das thermoelektrische Element aus einer positiven N-Typ-Legierung und der Mantel aus einer Legierung gebildet sind, die aus den Legierungen (b), (b1), (b2) und (b3) ausgewählt ist, wobei
Legierung (b) von 3,0 bis 5,0 Gewichtsprozent Silicium, von 0,03 bis 0,25 Gewichtsprozent Magnesium und im übrigen Nickel umfaßt mit Verunreinigungsgraden an Chrom, Eisen und Kohlenstoff, die 0,05, 0,15 bzw. 0,05 Gewichtsprozent nicht überschreiten;
Legierung (b1) von 4,0 bis 4,8 Gewichtsprozent Silicium, von 0,05 bis 0,20 Gewichtsprozent Magnesium und im übrigen Nickel umfaßt, mit Verunreinigungsgraden an Chrom, Eisen und Kohlenstoff, die 0,05, 0,15 bzw. 0,05 Gewichtsprozent nicht überschreiten;
Legierung (b2) von 4,2 bis 4,6 Gewichtsprozent Silicium, von 0,10 bis 0,20 Gewichtsprozent Magnesium, maximal 0,05 Gewichtsprozent Chrom, maximal 0,15 Gewichtsprozent Eisen, maximal 0,05 Gewichtsprozent Kohlenstoff und im übrigen Nickel umfaßt; und
Legierung (b3) 4,4 Gewichtsprozent Silicium, 0,1 Gewichtsprozent Eisen, 0,1 Gewichtsprozent Magnesium, maximal 0,05 Gewichtsprozent Chrom, maximal 0,05 Gewichtsprozent Kohlenstoff und im übrigen Nickel umfaßt.

14. Kabel nach Anspruch 1, bei dem das Kabel nur ein thermoelektrisches Element enthält, wobei das thermoelektrische Element aus einer negativen N-Typ-Legierung und der Mantel aus einer aus den Legierungen (a), (a1), (a2) und (a3) ausgewählten Legierung gebildet sind, wobei Legierung (a) von 13,0 bis 15,0 Gewichtsprozent Chrom, von 1,0 bis 2,0 Gewichtsprozent Silicium, von 0,03 bis 0,25 Gewichtsprozent Magnesium und im übrigen Nickel umfaßt, mit Verunreinigungsgraden an Eisen und Kohlenstoff, die 0,15 bzw. 0,05 Gewichtsprozent nicht überschreiten;

Legierung (a1) von 13,9 bis 14,5 Gewichtsprozent Chrom, von 1,3 bis 1,5 Gewichtsprozent Silicium, von 0,05 bis 0,20 Gewichtsprozent Magnesium und im übrigen Nickel umfaßt, mit Verunreinigungsgraden an Eisen und Kohlenstoff, die 0,15 bzw. 0,05 Gewichtsprozent nicht überschreiten;

Legierung (a) von 14,05 bis 14,35 Gewichtsprozent Chrom, von 1,35 bis 1,45 Gewichtsprozent Silicium, von 0,10 bis 0,20 Gewichtsprozent Magnesium, maximal 0,15 Gewichtsprozent Eisen, maximal 0,05 Gewichtsprozent Kohlenstoff und im übrigen Nickel umfaßt; und

Legierung (a3) 14,2 Gewichtsprozent Chrom, 1,4 Gewichtsprozent Silicium, 0,1 Gewichtsprozent Eisen, 0,03 Gewichtsprozent Magnesium, maximal 0,05 Gewichtsprozent Kohlenstoff und im übrigen Nickel umfaßt.

15. Widerstandsheizkabel, insbesondere brauchbar zum Betrieb bei hohen Temperaturen, das ein Kabel gemäß Anspruch 1 umfaßt, bei dem das oder jedes thermoelektrische Element ein Widerstandsheizelement ist, und der Mantel aus einer Legierung gebildet ist, die aus positiven N-Typ-Legierungen, negativen N-Typ-Legierungen und in den Ansprüchen 13 und 14 definierten Legierungen (a), (a1), (a2), (a3), (b), (b1), (b2) und (b3) ausgewählt ist.

16. Widerstandsheizelement nach Anspruch 15, bei dem die Mantellegierung durch das Hinzufügen einer oder mehrerer Komponenten verstärkt ist, die zum Zwecke der Erhöhung mechanischer Festigkeit dieser Legierungen bei hoher Temperatur bekannt sind.

17. Widerstandsheizelement nach Anspruch 16, bei dem die Komponenten aus Mangan, Eisen, Molybdän, Kobalt, Wolfram und Dispersionen aus Oxyd-Partikeln ausgewählt sind.

18. Wärmedetektor, betreibbar bei Temperaturen oberhalb 1100° C, der ein langgestrecktes, verdichtetes, mineralisch isoliertes, mit integriertem Mantel versehenes Kabel, wie in einem der Ansprüche 1 bis 14 definiert, umfaßt, das in einer Umgebung angeordnet ist, in der lokale Temperaturerhöhungen vorkommen können, welche ein lokales Anwachsen der Leitfähigkeit des isolierenden Materials verursachen, wobei der Detektor Mittel zur Bestimmung des Ortes dieses lokalen Anwachsens der Leitfähigkeit und folglich des Ortes der Temperaturerhöhung einschließt.

19. Staurohr-Temperatursonde, die ein N-Typ-Thermoelement als Temperaturfühler einschließt, wobei das Themoelement aus einem Kabel, wie in den Ansprüchen 1 bis 14 definiert, hergestellt ist.

**Revendications**

1. Câble intégralement gainé, isolé par un minéral tassé, dans lequel le câble possède au moins un thermocouple constitué par un alliage de type N et la gaine est constituée par un alliage choisi parmi les alliages (a) et (b), l'alliage (a) comprend entre 13,0 pour cent en poids et 15,0 pour cent en poids de chrome, entre 1,0 pour cent en poids en poids et 2,0 pour cent en poids de silicium, entre 0,03 pour cent en poids et 0,25 pour cent en poids de magnésium, le reste étant formé de nickel, avec des niveaux d'impuretés de fer et de carbone ne dépassant respectivement pas 0,15 pour cent en poids et 0,05 pour cent en poids en poids, et l'alliage (b) comprend entre 3,0 pour cent en poids et 5,0 pour cent en poids de silicium, entre 0,03 pour cent en poids et 0,25 pour cent en poids de magnésium, le reste étant formé de nickel, avec des niveaux d'impuretés de chrome, de fer et de carbone ne dépassant pas respectivement 0,05 pour cent en poids, 0,15 pour cent en poids et 0,05 pour cent en poids.

2. Câble selon la revendication 1, dans lequel la gaine est constituée par un alliage (a1) comprenant essentiellement entre 13,9 pour cent en poids et 14,5 pour cent en poids de chrome, entre 1,3 pour cent en poids et 1,5 pour cent en poids de silicium, entre 0,05 pour cent en poids et 0,1 pour cent en poids de magnésium, le reste étant formé de nickel, avec des niveaux d'impuretés de fer et de carbone ne dépassant pas respectivement 0,15 pour cent en poids et 0,05 pour cent en poids.

3. Câble selon la revendication 1, dans lequel la gaine est constituée par un alliage (a2) contenant

EP 0 161 986 B1

essentiellement entre 14,05 pour cent en poids et 14,35 pour cent en poids de chrome, entre 1,35 pour cent en poids et 1,45 pour cent en poids de silicium, entre 0,10 pour cent en poids et 0,20 pour cent en poids de magnésium, au maximum 0,15 pour cent en poids de fer, au maximum 0,05 pour cent en poids de carbone, le reste étant formé de nickel.

4. Câble selon la revendication 1, dans lequel la gaine est constituée par un alliage (a3) composé essentiellement de 14,2 pour cent en poids de chrome, 1,4 pour cent en poids de silicium, 0,1 pour cent en poids en poids de fer, 0,03 pour cent en poids de magnésium, au maximum 0,05 pour cent en poids de carbone et le reste étant formé de nickel.

5. Câble selon la revendication 1, dans lequel la gaine est constituée par un alliage (b1) comprenant essentiellement entre 4,0 pour cent en poids et 4,8 pour cent en poids en poids de silicium, entre 0,05 pour cent en poids et 0,20 pour cent en poids de magnésium, le reste étant formé de nickel, avec des niveaux d'impuretés de chrome, de fer et de carbone ne dépassant pas respectivement 0,05 pour cent en poids, 0,15 pour cent en poids et 0,05 pour cent en poids.

6. Câble selon la revendication 1, dans lequel la gaine est constituée par un alliage (b2) comprenant essentiellement entre 4,2 pour cent en poids et 4,6 pour cent en poids de silicium, entre 0,10 pour cent en poids et 0,20 pour cent en poids de magnésium, au maximum 0,05 pour cent en poids de chrome, au maximum 0,15 pour cent en poids de fer, au maximum 0,05 pour cent en poids de carbone, le reste étant formé de nickel.

7. Câble selon la revendication 1, dans lequel la gaine est constituée par un alliage (b3) comprenant essentiellement 4,4 pour cent en poids de silicium, 0,1 pour cent en poids de fer, 0,1 pour cent en poids de magnésium, au maximum 0,05 pour cent en poids de chrome, au maximum 0,05 pour cent en poids de carbone, le reste étant formé de nickel.

8. Câble selon la revendication 1, dans lequel le câble comprend un thermocouple constitué par un alliage positif de type N et un thermocouple constitué par un alliage négatif de type N, et la gaine est constituée par un alliage positif de type N.

9. Câble selon la revendication 1, dans lequel le câble comprend un thermocouple constitué par un alliage positif de type N et un thermocouple constitué par un alliage négatif de type N et la gaine est constituée par un alliage négatif de type N.

10. Câble selon la revendication 1, dans lequel le câble comprend seulement un thermocouple, ledit thermocouple est constitué par un alliage positif de type N et la gaine est constituée par un alliage négatif de type N.

11. Câble selon la revendication 1, dans lequel le câble contient un seul thermocouple, ledit thermocouple est constitué par un alliage négatif de type N et la gaine est constituée par un alliage positif de type P.

12. Câble selon l'une quelconque des revendications 1 à 7, dans lequel le câble inclut un thermocouple constitué par un alliage positif de type N et un thermocouple constitué par un alliage négatif de type N.

13. Câble selon la revendication 1, dans lequel le câble comprend un seul thermocouple, ledit thermocouple est constitué par un alliage positif de type N et la gaine est constituée par un alliage choisi parmi les alliages (b), (b1), (b2) et (03), parmi lesquels
l'alliage (b) comprend entre 3,0 pour cent en poids et 5,0 pour cent en poids de silicium, entre 0,03 pour cent en poids et 0,25 pour cent en poids de magnésium, le reste étant formé de nickel, avec des niveaux d'impuretés de chrome, de fer et de carbone ne dépassant pas respectivement 0,05 pour cent en poids, 0,15 pour cent en poids et 0,05 pour cent en poids;
l'alliage (b1) comprend entre 4,0 pour cent en poids et 4,8 pour cent en poids de silicium, entre 0,05 pour cent en poids et 0,20 pour cent en poids de magnésium, le reste étant formé de nickel, avec des niveaux d'impuretés de chrome, de fer et de carbone ne dépassant pas respectivement 0,05 pour cent en poids, 0,15 pour cent en poids et 0,05 pour cent en poids;
l'alliage (b2) comprend entre 4,2 pour cent en poids et 4,6 pour cent en poids de silicium, entre 0,10 pour cent en poids et 0,2 pour cent en poids en poids de magnésium, au maximum 0,05 pour cent en

14

poids de chrome, au maximum 0,15 pour cent en poids de fer, au maximum 0,05 pour cent en poids de carbone, le reste étant formé de nickel; et

l'alliage (b3) comprend 4,4 pour cent en poids de silicium, 0,1 pour cent en poids de fer, 0,1 pour cent en poids de magnésium, au maximum 0,05 pour cent en poids de chrome, au maximum 0,05 pour cent en poids de carbone et le reste étant formé de nickel.

14. Câble selon la revendication 1, dans lequel le câble contient seulement un thermocouple, ledit thermocouple est constitué par un alliage négatif de type M et la gaine est constituée d'un alliage choisi parmi les alliages (a), (a1), (a2) et (a3), parmi lesquels

l'alliage (a) comprend entre 13,0 pour cent en poids et 15,0 pour cent en poids de chrome, entre 1,0 pour cent en poids et 2,0 pour cent en poids de silicium, entre 0,03 pour cent en poids et 0,25 pour cent en poids de magnésium, le reste étant formé de nickel, avec des niveaux d'impuretés en fer et en carbone ne dépassant pas respectivement 0,15 pour cent en poids et 0,05 pour cent en poids;

l'alliage (a1) comprend entre 13,9 pour cent en poids et 14,5 pour cent en poids de chrome, entre 1,3 pour cent en poids et 1,5 pour cent en poids de silicium, entre 0,05 pour cent en poids et 0,20 pour cent en poids de magnésium, le reste étant formé de nickel, avec des niveaux d'impuretés de fer et de carbone ne dépassant pas respectivement 0,15 pour cent en poids et 0,05 pour cent en poids;

l'alliage (a2) comprend entre 14,05 pour cent en poids et 14,35 pour cent en poids de chrome, entre 1,35 pour cent en poids et 1,45 pour cent en poids de silicium, entre 0,10 pour cent en poids et 0,20 pour cent en poids de magnésium, au maximum 0,15 pour cent en poids de fer, au maximum 0,05 pour cent en poids de carbone et le reste étant formé de nickel; et

l'alliage (a3) comprend 14,2 pour cent en poids de chrome, 1,4 pour cent en poids de silicium, 0,1 pour cent en poids de fer, 0,03 pour cent en poids de magnésium, au maximum 0,05 pour cent en poids de carbone, le reste étant formé de nickel.

15. Câble de chauffage résistif particulièrement utile pour fonctionner à des températures élevées, comprenant un câble selon la revendication 1,

dans lequel le ou chaque thermocouple est un élément chauffant résistif et la gaine est constituée par un alliage choisi parmi des alliages positifs de type N, des alliages négatifs de type N, et des alliages (a), (a1), (a2), (a3), (b), (b1), (b2) et (b3) tels que définis dans les revendications 13 et 14.

16. Élément chauffant résistif selon la revendication 15, dans lequel l'alliage de la gaine est renforcé par l'addition d'un ou de plusieurs composants connus pour leur rôle d'accroissement de la résistance mécanique desdits alliages à haute température.

17. Élément chauffant résistif selon la revendication 16, dans lequel lesdits composants sont choisis parmi le manganèse, le fer, le molybdène, le cobalt, le tungstène et des dispersions de particules d'oxyde.

18. Détecteur de chaleur pouvant fonctionner à des températures dépassant 1100°C et comprenant un câble allongé gainé d'un seul tenant, isolé par un minéral tassé, tel que défini dans l'une quelconque des revendications 1 à 14, et disposé dans un environnement dans lequel des accroissements locaux de température peuvent se produire, ce qui provoque un accroissement local de la conductivité du matériau isolant, lesdits détecteurs comprenant des moyens pour déterminer l'emplacement dudit accroissement local de la conductivité et par conséquent l'emplacement de ladite montée de température.

19. Sonde de température de stagnation comprenant un thermocouple de type N en tant que capteur de température, ledit thermocouple étant formé à partir d'un câble tel que défini dans l'une quelconque des revendications 1 à 14.

1

3

2

FIG _ 1 _

a   b   c   d   e   f

g   d

FIG _ 2 _

h   i   j

k   l   m   n

LOG RESISTANCE

LOG   TEMPERATURE

FIG _ 3 _

16